# EUROPÄISCHE PATENTSCHRIFT

(11) **EP 1 373 982 B1**
(45) Veröffentlichungstag und Bekanntmachung des Hinweises auf die Patenterteilung: **30.11.2005**
(21) Anmeldenummer: 02727401.8
(22) Anmeldetag: 12.03.2002
(51) Int. Cl.: G03F 7/20

(54) **Verfahren zur Overlay-Einstellung zweier Maskenebenen bei einem photolithographischen Prozess**
Method for adjusting the overlay of two masking levels in a photolithographic process
Méthode de réglage de la superposition de deux niveaux de masquage dans un procédé photolithographique

(30) Priorität: 28.03.2001 DE 10115281
(43) Veröffentlichungstag der Anmeldung: 02.01.2004
(73) Patentinhaber: Infineon Technologies AG, 81669 München (DE)
(72) Erfinder: HASSMANN, Jens, 01796 Pirna (DE)
(74) Vertreter: Barth, Stephan Manuel
(86) Internationale Anmeldenummer: PCT/EP2002/002704
(87) Internationale Veröffentlichungsnummer: WO 2002/079880

(56) Entgegenhaltungen:
- US-A- 5 444 538
- ARMITAGE JR, J.D ET AL.: "Analysis of overlay distortion patterns" SPIE PROCEEDINGS, Bd. 921, 1988, Seiten 207-221, XP008015147 Bellingham US
- PROGLER C ET AL: "Method to budget and optimize total device overlay" OPTICAL MICROLITHOGRAPHY XII, SANTA CLARA, CA, USA, 17-19 MARCH 1999, Bd. 3679, pt.1-2, Seiten 193-207, XP008015148 Proceedings of the SPIE - The International Society for Optical Engineering, 1999, SPIE-Int. Soc. Opt. Eng, USA ISSN: 0277-786X

## Beschreibung

Die vorliegende Erfindung betrifft ein Verfahren zur Optimierung der Overlay-Einstellung zweier Maskenebenen bei einem photolithographischen Prozess zur Herstellung einer integrierten Schaltung.

Aus SPIE Proceedings, Volume 921, Seiten 207-221; XP 008 015 147 ist ein Verfahren zum Analysieren von Overlay-Fehlern in verschiedene Komponenten bekannt.

Aus SPIE Proceedings, Volume 3679, Seiten 193-207; XP 008 015 148 ist ein Verfahren zum Vorhersagen von Overlay-Fehlern bekannt, welches verschiedene Fehlerkomponenten separieren kann.

Aus der U.S.-A-5,444,538 ist ein System zum Optimieren von Overlay-Fehlern bekannt, bei dem eine Mehrzahl von Fehlausrichtungsvektoren gemessen wird und anschließend eine Minimierung basierend auf den bestimmten Fehlausrichtungsvektoren durchgeführt wird.

Diese Dokumente offenbaren die Identifizierung und Korrektur verschiedener Ursachen von Overlay-Fehlern, wobei manche Fehler als nicht-korrigierbar angesehen werden. Diese Dokumente offenbaren jedoch nicht die Korrektur der Ausrichtung der Maske für die zweite Maskenebenen unter Berücksichtigung von mittels eines geneinsamen Referenzgitters erhaltenen Daten über nicht-korrigierbare Fehler der Masker und/oder Belichtungsgeräte für die zwei Maskenebenen.

Die Herstellung integrierter Schaltungen in Halbleitertechnologie erfolgt üblicherweise in mehreren Maskenebenen, die möglichst deckungsgleich zueinander orientiert sein müssen. Mit steigender Integrationsdichte erhöhen sich die Anforderungen an die Überdeckungsgenauigkeit (auch als Overlay bezeichnet).

Um möglichst eindeutige Aussagen über die Overlay-Qualität treffen zu können und entsprechende Korrekturen durchführen zu können, sollten systematische Fehlerquellen möglichst bekannt und damit eliminierbar sein. Die bei der Lithographie auftretenden Fehlerquellen hinsichtlich Überdeckungsgenauigkeit sind u.a. die Toleranzen der Photomasken, welche in den einzelnen Lithographieschritten eingesetzt werden, und die Fehler der eingesetzten Belichtungsgeräte, wie z.B. Verzeichnung bzw. Distorsion von Projektionsoptiken.

Bei bekannten Verfahren zur Overlay-Einstellung zweier Maskenebenen wurden diese Fehlerquellen bisher nicht in direkter Weise berücksichtigt. Maskentoleranzen und Linsenverzeichnungen bzw. Distorsionen wurden zwar spezifiziert und für die Kombination von Belichtungsgeräten berücksichtigt, flossen aber noch nicht direkt in die Auswertung von Overlay-Messungen mit ein.

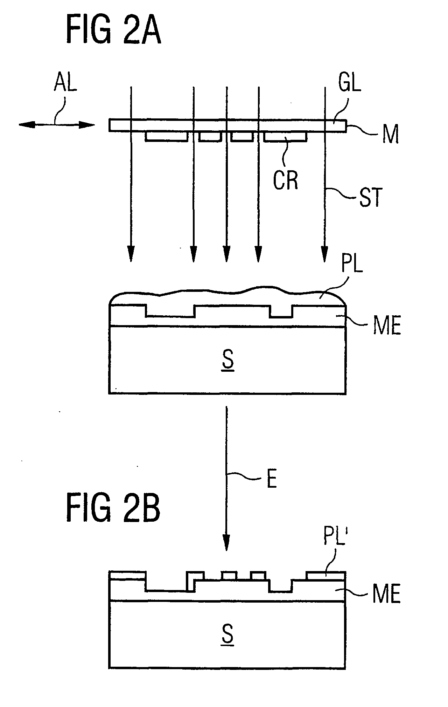

Fig. 2a,b zeigen eine schematische Darstellung eines photolithographischen Prozesse zur Herstellung einer integrierten Schaltung.

Gemäß Figur 2a ist ein Substrat S vorgesehen, welches eine erste Maskenebene ME trägt, welche durch Belichtung einer (nicht gezeigten) ersten Maske mit einem ersten Belichtungsgerät strukturiert wurde. Im Anschluss daran (und weiterer notwendiger Prozessschritte zur Herstellung integrierter Bauelemente) wird auf die erste Maskenebene eine Photolackschicht PL aufgetragen. Dann erfolgt das Ausrichten AL einer zweiten Maske M zur ersten Maskenebene ME anhand von vorgesehenen Referenzmarken im Substrat, wobei die zweite Maske M zur Strukturierung einer zweiten Maskenebene aus produktionsbedingten Gründen mit einem zweiten Belichtungsgerät vorgesehen sein kann.

Die Masken bestehen üblicherweise aus einem durchsichtigen Glasträger GL, auf dessen einer Seite eine strukturierte Chromschicht CR vorgesehen ist. Lichtstrahlen ST können die Maske an den Stellen passieren, an denen kein Chrom vorgesehen ist und somit den Photolack PL belichten und so darauf die Maskenstruktur auf den Photolack PL übertragen.

Gemäß Figur 2b erfolgt nach der Belichtung durch die Lichtstrahlen ST ein Entwicklungsprozess E, bei dem im Falle von Positivlack die belichteten Stellen aus der Photolackschicht PL herausgelöst werden, was zu einer strukturierten Photolackschicht PL' führt. Eine anschließende Overlay-Messung der Ebene PL' zur Ebene ME liefert eine Aussage zur Qualität der Überdeckungsgenauigkeit der beiden Ebenen.

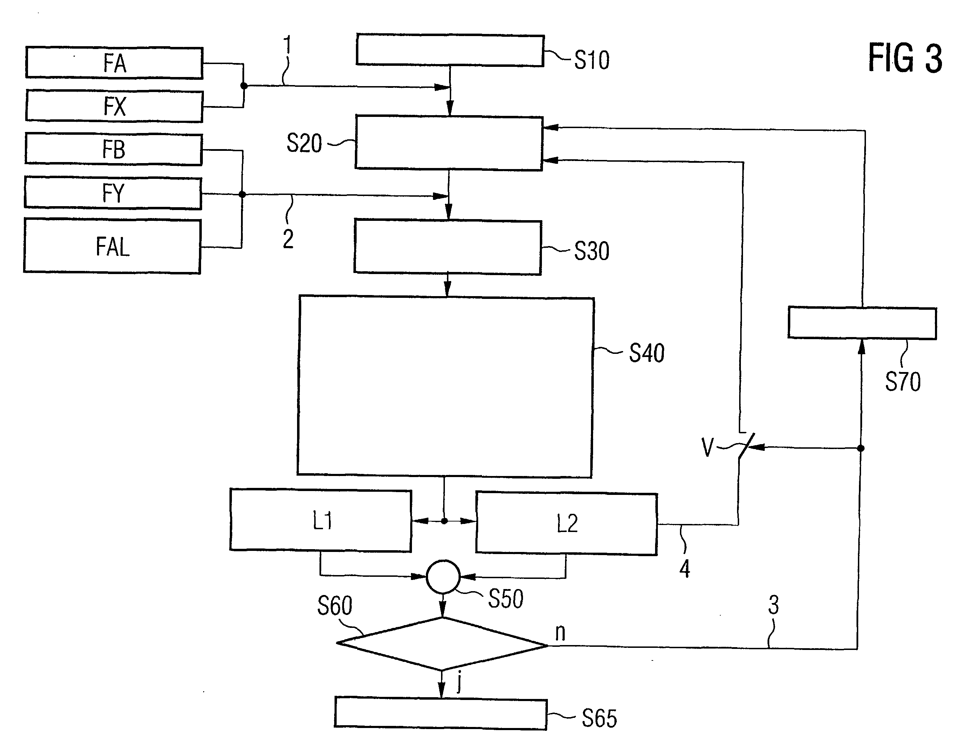

Fig. 3 zeigt die wesentlichen Schritte eines bekannten Verfahrens zur Overlayeinstellung zweier Maskenebenen bei einem photolithographischen Prozess mit Feedback-Schleife zur Herstellung einer integrierten Schaltung.

Das bekannte Verfahren beginnt mit Schritt S10, in dem ein Substrat S mit einer ersten Maskenebene ME bereitgestellt wird. Wie durch den Pfeil 1 gezeigt, sind hier bereits Fehlerfaktoren für das spätere Overlay vorhanden, nämlich Maskenfehler FA einer ersten Maske, welche zur Schaffung der ersten Maskenebene ME verwendet wurde, sowie Belichtungsfehler FX, welche von dem ersten Belichtungsgerät herrühren, mit dem die erste Maske belichtet wurde.

In Schritt S20 (Lithographieprozess) erfolgt dann ein Ausrichten der zweiten Maske M zur ersten Maskenebene ME. Hierbei treten weitere Fehlergrößen für das Overlay auf, was mit dem Pfeil 2 angedeutet ist. Insbesondere sind dies die Maskenfehler FB der zweiten Maske M, die Belichtungsfehler FY des zweiten Belichtungsgeräts, welches zur Belichtung der Maske M verwendet wird, sowie prozess- und anlagenbedingte Ausrichtungsfehler FAL von Maske M zum Substrat.

Die Anteile höherer Ordnung der Maskenfehler FA und FB sowie der Belichtungsfehler FX und FY (Distorsionen) werden in der Regel als für das Belichtungsgerät nicht korrigierbare Fehler angesehen.

Im folgenden Schritt S30 wird dann das Overlay zwischen der ersten Maskenebene ME und der zweiten Maske M gemessen. Dies erfolgt durch übliche Verfahren, wie z.B. Box-in-Box-Messungen an ausgewählten Stellen auf dem prozessierten Substrat.

Anschließend in Schritt S40 erfolgt eine Analyse des Messresultats der Overlay-Messung von Schritt S30. Eine derartige Analyse wird üblicherweise mit Hilfe eines Softwareprogramms durchgeführt, welches digitalisierte Messdaten gemäß einem vorbestimmten Algorithmus analysiert. Ziel der Auswertung ist zum einen die Bewertung der Überdeckungsgenauigkeit, zum anderen die Voraussage über den Erfolg einer eventuell notwendigen erneuten Bearbeitung des Substrats einschließlich der dafür notwendigen Korrekturparameter.

Nachteilhafterweise ermöglicht die bekannte Overlay-Analyse keine Unterscheidung verschiedener Fehlereinflüsse der Fehler FA, FX, FB, FY, FAL oder sonstiger Fehler. Somit lässt sich nur sehr global eine Differenzierung in eine Liste für Belichtungsanlagen unkorrigierbarer Fehler L1, wie z.B. zufällig verteilte Fehlerbilder (Distorsionen), und eine Liste korrigierbarer Fehler L2, wie z.B. Verdrehung, Verschiebung o.ä., realisieren.

Anhand der Listen L1, L2 wird dann in Schritt S50 eine Bewertung nach vorbestimmten Kriterien der Overlay-Analyse vorgenommen. Das Bewertungsergebnis wird in Schritt S60 mit einer vorbestimmten Spezifikation verglichen. Ergibt der Vergleich in Schritt S60, dass das Overlay innerhalb der Spezifikationsgrenzen liegt und somit der Overlay-Anteil am Lithographieprozess als erfolgreich angesehen wird, so kann in Schritt S65 mit der weitern Bearbeitung des Substrats fortgefahren werden.

Ist die Antwort in Schritt S60 nein, so wird eine Nachbearbeitung in Schritt S70 initiiert, was durch den Pfeil 3 angedeutet ist. Insbesondere veranlasst eine derartige Nachbearbeitung, dass die korrigierbaren Fehler gemäß der Liste L2 bei der Wiederholung des Schrittes S20 zur Verfügung stehen, was durch das Schließen der Verbindung V angedeutet ist. Mit anderen Worten können bei einer erneuten Durchführung des Schrittes S20 erkannte korrigierbare Fehler, wie z.B. Verdrehungen oder Verschiebungen, berücksichtigt werden.

Es ist Aufgabe der vorliegenden Erfindung, ein Verfahren zur Overlayeinstellung zweier Maskenebenen bei einem photolithographischen Prozess zur Herstellung einer integrierten Schaltung zu schaffen, womit eine bessere Fehleranalyse und anschließende Fehlerkorrektur des Overlays möglich ist.

Erfindungsgemäß wird diese Aufgabe durch das in Anspruch 1 angegebene Verfahren zur Overlayeinstellung zweier Maskenebenen bei einem photolithographischen Prozess zur Herstellung einer integrierten Schaltung gelöst.

Die der vorliegenden Erfindung zugrundeliegende Idee besteht darin, dass die Masken und/oder die Belichtungsgeräte im voraus mit einem Referenzgitter vermessen werden und die daraus erhaltenen Daten in einer Datenbank nicht korrigierbarer Fehler hinterlegt werden. Später bei der Overlay-Analyse werden diese Fehlerdaten mitberücksichtigt, was eine einfachere Separation nicht-korrigierbarer und korrigierbarer Fehler ermöglicht. Dies wiederum vereinfacht die Beurteilung, ob eine Nachbearbeitung sinnvoll ist und trägt demnach dazu bei, hoffnungslose Nachbearbeitungsschleifen zu vermeiden. Somit hilft das erfindungsgemäße Verfahren letztendlich, Prozesszeit und Anlagenkapazität zu sparen. Des weiteren werden in der Rückkopplungsschleife dem Belichtungsgerät nur tatsächlich korrigierbare Parameter zur Verfügung gestellt ohne überlagerte nichtkorrigierbare Anteile bzw. Überkompensation, was zur Verbesserung des Overlayergebnisses beiträgt.

In den Unteransprüchen finden sich vorteilhafte Weiterbildungen und Verbesserungen des erfindungsgemäßen Verfahrens zur Overlayeinstellung zweier Maskenebenen bei einem photolithographischen Prozess zur Herstellung einer integrierten Schaltung.

Gemäß einer bevorzugten Weiterbildung sieht das Analysieren eine Aufteilung in korrigierbare und nicht-korrigierbare Fehler vor.

Gemäß einer weiteren bevorzugten Weiterbildung wird der photolithgrapische Prozess unterbrochen, wenn entweder die Anzahl der Korrekturschritte einen vorbestimmten Wert überschreitet oder das vorausberechnete Ergebnis als nicht ausreichend beurteilt wird.

Gemäß einer weiteren bevorzugten Weiterbildung sieht das Analysieren eine Aufteilung in korrigierbare und nicht-korrigierbare Fehler vor und wird der photolithographische Prozess unterbrochen, wenn das Vergleichsergebnis außerhalb der Spezifikation liegt und gleichzeitig nur nicht-korrigierbare Fehler vorliegen.

Ein Ausführungsbeispiel der Erfindung ist in den Zeichnungen dargestellt und in der nachfolgenden Beschreibung näher erläutert.

Es zeigen:
- Fig. 1: die wesentlichen Schritte eines Verfahrens zur Overlayeinstellung zweier Maskenebenen bei einem photolithographischen Prozess zur Herstellung einer integrierten Schaltung als Ausführungsform der vorliegenden Erfindung;
- Fig. 2a,b: eine schematische Darstellung eines photolithographischen Prozesse zur Herstellung einer integrierten Schaltung; und
- Fig. 3: die wesentlichen Schritte eines bekannten Verfahrens zur Overlayeinstellung zweier Maskenebenen bei einem photolithographischen Prozess zur Herstellung einer integrierten Schaltung.

In den Figuren bezeichnen gleiche Bezugszeichen gleiche oder funktionsgleiche Bestandteile.

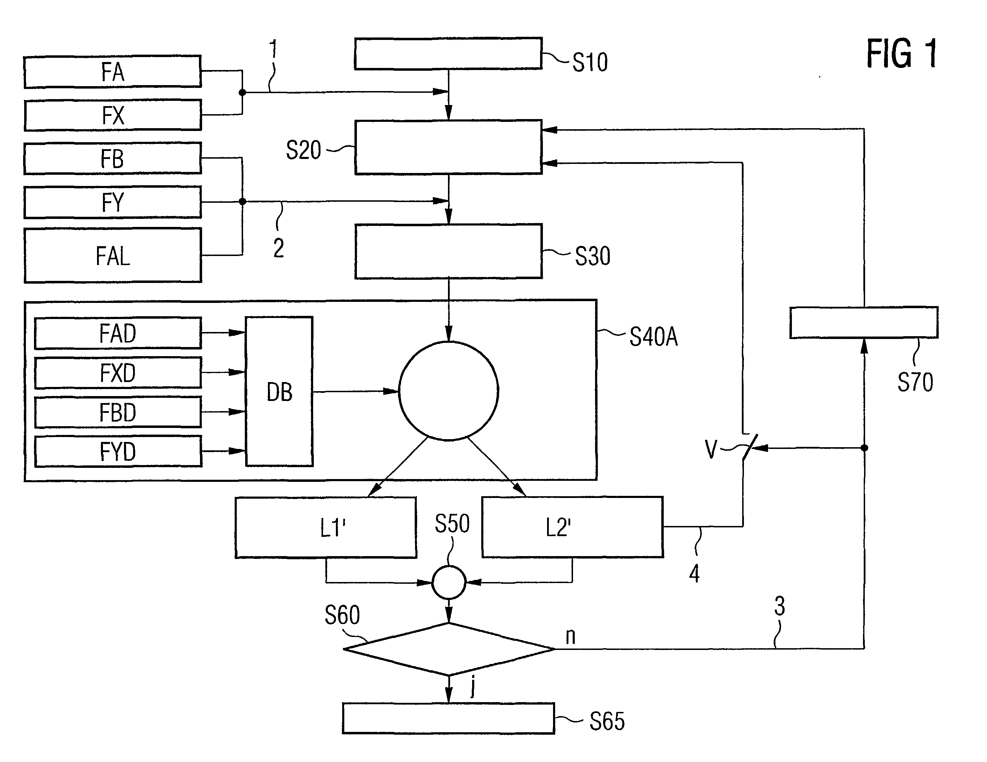

Fig. 1 zeigt die wesentlichen Schritte eines Verfahrens zur Overlayeinstellung zweier Maskenebenen bei einem photolithographischen Prozess zur Herstellung einer integrierten Schaltung als Ausführungsform der vorliegenden Erfindung.

Gemäß Fig. 1 erfolgen die Schritte S10 bis S30 ebenso wie beim bekannten Verfahren nach Fig. 3.

Insbesondere erfolgt in Schritt S 10 ein Bereitstellen des Substrats S mit der ersten Maskenebene ME, welche durch Belichtung der ersten Maske mit dem ersten Belichtungsgerät strukturiert wurde.

In Schritt S20 erfolgt danach das Ausrichten einer zweiten Maske M, die zur Strukturierung der zweiten Maskenebene mit dem zweiten Belichtungsgerät vorgesehen ist, zur ersten Maskenebene ME.

In Schritt S30 erfolgt schließlich das Messen des Overlays zwischen der ersten Maskenebene ME und zweiten Maske M.

Der folgende Schritt S40A unterscheidet sich wesentlich vom bekannten Schritt S40 gemäß Fig. 3, denn er ermöglicht die Unterscheidung verschiedener Fehlereinflüsse der Fehler FA, FX, FB, FY, FAL.

Bei dieser Ausführungsform erfolgte nämlich im voraus ein Bereitstellen von Fehlerdaten FAD, FXD, FBD, FYD über die besagten Fehler FA, FB der ersten und zweiten Maske und Fehler FX, FY des ersten und zweiten Belichtungsgeräts.

Diese Fehlerdaten FAD, FXD, FBD, FYD wurden durch eine Vermessung der ersten und zweiten Maske und der Abbildungen des ersten und zweiten Belichtungsgeräts mittels einem Referenzgitter (Registration) gewonnen. Anschließend werden die Fehlerdaten FAD, FXD, FBD, FYD in einer Datenbank DB gespeichert.

Die Vermessung von Maskenfehlern mit einem Referenzgitter kann z.B. unmittelbar nach der Maskenherstellung sehr einfach durchgeführt werden. Beispielsweise kann bei der Auslieferung jeder Maske eine Datei mit diesen Fehlerdaten angefügt werden, die in die Datenbank der Overlay-Analyse-Software aufgenommen wird.

Auch die Verzeichnung bzw. Distorsion der Linsensysteme der Belichtungsgeräte kann mit relativ einfachen Mitteln bestimmt werden, nämlich entweder mittels direkter Messung in einem geeichten Messgerät oder ebenfalls in bezug auf ein willkürlich festlegbares Referenzgitter, welches zweckmäßigerweise dem Referenzgitter entspricht, das für die Bestimmung der Maskenfehler verwendet wird.

Zweckmäßigerweise werden Referenzscheiben für die Verzeichnungs- bzw. Distorsionsbestimmung der Linsensysteme der Belichtungsgeräte mit demselben Messgerät vermessen, mit dem ebenfalls die eingesetzten Masken charakterisiert werden. Als Basis steht somit ein gemeinsames Referenzsystem zur Verfügung.

Werden die Daten aller dieser Messungen auf eine gemeinsame Referenz, wie die Datenbank DB, gestellt und entsprechend aufbereitet, so können sie bei der Auswertung der Overlay-Messung softwaretechnisch herangezogen werden. Dadurch können optimale Korrekturparameter vorgegeben werden, falls erforderlich.

Beim Analysieren des gemessenen Overlays in Schritt S40A werden also diese im voraus bereitgestellten Fehlerdaten FAD, FXD, FBD, FYD berücksichtigt, was dazu führt, dass die betreffenden Fehlerquellen separierbar sind. Demzufolge ist bei dieser Ausführungsform eine Aufteilung in korrigierbare Fehler in Liste L2' und nicht-korrigierbare Fehler in Liste L1' wesentlich einfacher und genauer möglich, da die systematischen Fehler separiert werden können.

Anhand der Listen L1', L2' wird dann in Schritt S50 wie beim bekannten Verfahren eine Bewertung nach vorbestimmten Kriterien der Overlay-Analyse vorgenommen. Das Bewertungsergebnis wird in Schritt S60 mit einer vorbestimmten Spezifikation verglichen.

Ergibt der Vergleich in Schritt S60, dass das Overlay innerhalb der Spezifikationsgrenzen liegt, so kann in Schritt S65 mit der planmäßigen Weiterbearbeitung fortgesetzt. Ist die Antwort in Schritt S60 nein, so wird eine Nachbearbeitung in Schritt S70 initiiert, was durch den Pfeil 3 angedeutet ist. Insbesondere veranlasst eine derartige Nachbearbeitung, dass die korrigierbaren Fehler gemäß der Liste L2' durch das angedeutete Schließen der Verbindung V bei der Wiederholung des Schrittes S20 zur Verfügung stehen. Mit anderen Worten können bei einer erneuten Durchführung des Schrittes S20 erkannte korrigierbare Fehler, wie z.B. Verdrehungen oder Verschiebungen, beseitigt werden.

Obwohl die vorliegende Erfindung vorstehend anhand bevorzugter Ausführungsbeispiele beschrieben wurde, ist sie darauf nicht beschränkt, sondern auf vielfältige Art und Weise modifizierbar.

Insbesondere kann der photolithographische Prozess unterbrochen werden, wenn entweder die Anzahl der als notwendig erachteten Korrekturschritte einen vorbestimmten Wert überschreitet oder das zu erzielende Overlay-Ergebnis selbst nach erfolgter Nachbearbeitung mit den berechneten Korrekturwerten nicht mit der vorgegebenen Spezifikation in Einklang zu bringen ist.

Auch kann die Feedback-Schleife des photolithographischen Prozesses unterbrochen, wenn das Vergleichsergebnis außerhalb der Spezifikation liegt und gleichzeitig nur nicht-korrigierbare Fehler vorliegen.

Auch können weitere Parameter systematisch erfasst und in Schritt S40A berücksichtigt werden, wie z.B. Prozessparameter o.ä..

### BEZUGSZEICHENLISTE:

| | |
|---|---|
| FA, FB | Maskenfehler |
| FX, FY | Fehler der Belichtungsgeräte |
| FAD, FBD | Maskenfehlerdaten |
| FXD, FYD | Fehlerdaten der Belichtungsgeräte |
| DB | Datenbank |
| V | Verbindung |
| L1,L1' | Liste nicht-korrigierbarer Fehler |
| L2,L2' | Liste korrigierbarer Fehler |
| 1-4 | Pfeile |
| S10-S70 | Schritte |
| AL | Ausrichtung |
| GL | Glasträger |
| CR | Chromschicht |
| M | Maske |
| ST | Lichtstrahlen |
| PL, PL' | Photolack |
| ME | Maskenebene |
| S | Substrat |
| E | Entwickeln |

## Patentansprüche

1. Verfahren zur Overlay-Einstellung zweier Maskenebenen (ME, PL') bei einem photolithographischen Prozess zur Herstellung einer integrierten Schaltung mit den Schritten:
Bereitstellen eines Substrats (S) mit mindestens einer ersten Maskenebene (ME), welche durch Belichtung einer ersten Maske mit einem ersten Belichtungsgerät strukturiert wurde;
Ausrichten einer zweiten Maske (M), die zur Strukturierung einer zweiten Maskenebene mit einem zweiten Belichtungsgerät vorgesehen ist, zur ersten Maskenebene (ME); und
Messen des Overlays zwischen der ersten Maskenebene (ME) und der zweiten Maskenebene (PL'); gekennzeichet durch die Schritte:
Bereitstellen von in einer Datenbank (DB) gespeicherten nicht-korrigierbaren Fehlerdaten (FAD, FXD, FBD, FYD) über Fehler (FA, FX, FB, FY) der ersten und zweiten Maske und/oder Fehler des ersten und zweiten Belichtungsgeräts durch eine Vermessung mittels einem gemeinsamen Referenzgitter;
Analysieren des gemessenen Overlays unter Berücksichtigung von den im voraus bereitgestellten nicht-korrigierbaren Fehlerdaten (FAD, FXD, FBD, FYD) über die Fehler (FA, FX, FB, FY) der ersten und zweiten Maske und/oder Fehler des ersten und zweiten Belichtungsgeräts;
Vergleichen des Analyseergebnisses mit einer vorbestimmten Spezifikation; und
Durchführen eines Korrekturschritts zur Korrektur der Ausrichtung der zweiten Maske (M) in Abhängigkeit vom Vergleichsergebnis.

2. Verfahren nach Anspruch 1,
weiter **dadurch gekennzeichnet,**
**dass** das Analysieren eine Aufteilung in korrigierbare und nicht-korrigierbare Fehler (L1', L2') vorsieht.

3. Verfahren nach Anspruch 2,
weiter **dadurch gekennzeichnet,**
**dass** der photolithographische Prozess unterbrochen wird, wenn das Vergleichsergebnis außerhalb der Spezifikation liegt und gleichzeitig nur nicht-korrigierbare Fehler (L1') vorliegen.

4. Verfahren nach Anspruch 1,
weiter **dadurch gekennzeichnet,**
**dass** der photolithographische Prozess unterbrochen wird, wenn die Anzahl der Korrekturschritte einen vorbestimmten Wert überschreitet oder das vorausberechnete Ergebnis als nicht ausreichend beurteilt wird.

## Claims

1. Method for adjusting the overlay of two mask planes (ME, PL') in a photolithographic process for the production of an integrated circuit having the following steps:
provision of a substrate (S) with at least one first mask plane (ME), which has been patterned by exposure of a first mask using a first exposure device;
orientation of a second mask (M), which is provided for the patterning of a second mask plane using a second exposure device, with respect to the first mask plane (ME); and
measurement of the overlay between the first mask plane (ME) and the second mask plane (PL'); **characterized by** the following steps:
provision of non-correctable error data (FAD, FXD, FBD, FYD) - stored in a database (DB) - regarding errors (FA, FX, FB, FY) of the first and second masks and/or errors of the first and second exposure devices by a measurement by means of a common reference grid;
analysis of the measured overlay taking account of the non-correctable error data (FAD, FXD, FBD, FYD) provided in advance regarding the errors (FA, FX, FB, FY) of the first and second masks and/or errors of the first and second exposure devices;
comparison of the result of the analysis with a predetermined specification; and
carrying out of a. correction step for the correction of the orientation of the second mask (M) depending on the result of the comparison.

2. Method according to Claim 1,
further **characterized**
**in that** the analysis provides a division into correctable and non-correctable errors (L1', L2').

3. Method according to Claim 2,
further **characterized**
**in that** the photolithographic process is interrupted if the result of the comparison lies outside the specification and, at the same time, only non-correctable errors (L1') are present.

4. Method according to Claim 1,
further **characterized**
**in that** the photolithographic process is interrupted if the number of correction steps exceeds a predetermined value or the predicted result is assessed as insufficient.

## Revendications

1. Méthode de réglage de la superposition de deux niveaux de masquage (ME, PL') dans un procédé photolithographique pour la fabrication d'un circuit intégré avec les étapes :
mise à disposition d'un substrat (S) avec au moins un premier niveau de masquage (ME) qui a été structuré par l'exposition d'un premier masque avec un premier appareil d'exposition ;
alignement d'un deuxième masque (M) par rapport au premier niveau de masquage (ME), le deuxième masque (M) étant prévu pour la structuration d'un deuxième niveau de masquage avec un deuxième appareil d'exposition ; et
mesure de la superposition entre le premier niveau de masquage (ME) et le deuxième niveau de masquage (PL') ; **caractérisée par** les étapes :
mise à disposition de données d'erreur (FAD, FXD, FBD, FYD) non corrigeables, mémorisées dans une base de données (DB), portant sur des erreurs (FA, FX, FB, FY) du premier et du deuxième masque et/ou des erreurs du premier et du deuxième appareil d'exposition, par un mesurage au moyen d'une grille de référence commune ;
analyse de la superposition mesurée en tenant compte des données d'erreur (FAD, FXD, FBD, FYD) non corrigeables, mises à disposition à l'avance et portant sur les erreurs (FA, FX, FB, FY) du premier et du deuxième masque et/ou les erreurs du premier et du deuxième appareil d'exposition ;
comparaison du résultat d'analyse avec une spécification prédéterminée ; et
réalisation d'une étape de correction pour corriger l'alignement du deuxième masque (M) en fonction du résultat de la comparaison.

2. Méthode selon la revendication 1,
**caractérisée, de plus, en ce que**
l'analyse prévoit une répartition des erreurs (L1', L2') en corrigeables et non-corrigeables.

3. Méthode selon la revendication 2,
**caractérisée, de plus, en ce que**
le procédé photolithographique est interrompu lorsque le résultat de la comparaison est en dehors de la spécification et qu'il n'y a, simultanément, que des erreurs (L1') non corrigeables.

4. Méthode selon la revendication 1,
**caractérisée, de plus, en ce que**
le procédé photolithographique est interrompu lorsque le nombre d'étapes de correction dépasse une valeur prédéterminée ou que le résultat calculé d'avance est estimé non satisfaisant.
